# EUROPEAN PATENT SPECIFICATION

(11) **EP 1 616 888 B1**
(45) Date of publication and mention of the grant of the patent: **11.07.2012**
(21) Application number: 04727426.1
(22) Date of filing: 14.04.2004
(51) Int. Cl.: H01L 21/027, G03F 7/26, G03F 7/09, G03F 7/095, G03F 7/022, G03F 7/00, C08G 8/12, C08G 8/08, G03F 7/11, G03F 7/023, C08G 8/04

(54) **RESIN FOR UNDER-LAYER MATERIAL, UNDER-LAYER MATERIAL, LAMINATE AND METHOD FOR FORMING RESIST PATTERN**
HARZ FÜR UNTERSCHICHTMATERIAL, UNTERSCHICHTMATERIAL, LAMINAT UND VERFAHREN ZUR BILDUNG EINES RESISTMUSTERS
RESINE POUR MATIERE DE SOUS-COUCHE, MATIERE DE SOUS-COUCHE, STRATIFIE ET PROCEDE DE FORMATION DE MOTIF DE RESIST

(30) Priority: 18.04.2003 JP 2003114044
(43) Date of publication of application: 18.01.2006
(73) Proprietor: TOKYO OHKA KOGYO CO., LTD., Kawasaki-shi, Kanagawa 211-0012 (JP)
(72) Inventor: NAKAMURA, Tsuyoshi c/o Tokyo Ohka Kogyo Co., Ltd., Kanagawa 211-0012 (JP)
(74) Representative: Hinkelmann, Klaus
(86) International application number: PCT/JP2004/005330
(87) International publication number: WO 2004/092238

(56) References cited:
- EP-A- 0 908 784
- JP-A- 1 177 032
- JP-A- 2 060 915
- JP-A- 3 125 152
- JP-A- 11 236 367
- JP-A- 61 099 351
- JP-A- 62 159 143
- JP-A- 62 174 737

## Description

### TECHNICAL FIELD

The present invention relates to a resin for an undercoating material, an undercoating material, a laminate, and a multilayered resist pattern forming method. This application claims priority from Japanese Patent Application No. 2003-114044 filed on April 18, 2003, the disclosure of which is incorporated by reference herein.

### BACKGROUND ART

In the field of a semiconductor device, considerable progresses of high integration and size-fining of the device have made recently. Among them, further progress has been made in shortening of the wavelength of exposure light. That is, although ultraviolet ray which is typified by g-ray and i-ray has conventionally been used, KrF excimer laser (248 nm) is introduced at present, and ArF excimer laser (193 nm) begins to be introduced in the field. Furthermore, studies have been made on F₂ excimer laser (157 nm), EUV (extreme ultraviolet ray), electron beam and X-ray, each having a shorter wavelength.

When exposure light having a shorter wavelength is used, light reflected from the substrate under exposure increases. Therefore, there arose problems such as local distortion and deterioration of dimensional accuracy of a resist pattern due to the reflected light. As a method of solving these problems, there is employed a BARC (Bottom Anti-Reflective Coating) method in which an anti-reflection layer is interposed between a substrate and a resist layer (see, for example, Japanese Unexamined Patent Application, First Publication No. Hei 10-228113).

The anti-reflection layer is commonly made of a composition comprising a resin for forming a coating film, a light-absorbing substance for absorbing reflected light and a crosslinking agent for thermally crosslinking them. At present, an acrylic resin is mainly used as a resin for forming a coating film when excimer laser such as KrF or ArF is used as exposure light.

In view of an exposure device, a numerical aperture (NA) of lens may be increased so as to further improve resolution. However, when NA increases, the depth of focus decreases. Therefore, when the surface of the substrate includes fine distorsion and irregularities and thus the photoresist layer includes distorsion and irregularities in thickness, it becomes difficult to accurately form a fine pattern. Therefore, it becomes necessary to attain a certain depth of focus, and there was a limit in increase of NA.

On the other hand, there has been made a formation of a flattening film between a substrate and a resist layer, thereby to flatten a surface to which a resist coating is provided, and thus a flat resist layer having a uniform thickness is formed (see, for example, Japanese Unexamined Patent Application, First Publication No. Hei 6-35201). Such a flattening technique enables the formation of a finer pattern due to an increase in NA.

As means for forming a pattern having a high aspect ratio, for example, there has been known a three-layer resist method comprising the steps of applying an undercoating material containing a resin for forming a coating film on a substrate, heating the undercoating material to form an organic film, forming thereon an intermediate film made of a silica-based inorganic film, and forming thereon a photoresist film. According to this method, a resist pattern is formed on the photoresist film by conventional photolithography and a pattern is transferred by etching the intermediate film using the resist pattern as a mask, and then the organic film is etched using the patterned intermediate film as a mask to form a pattern on the substrate (see, for example, Japanese Unexamined Patent Application, First Publication No. 2001-51422).

There is also proposed a two-layer resist method which is excellent in that the number of steps is less than that of the three-layer resist method (see, for example, Japanese Unexamined Patent Application, First Publication No. Sho 61-239243, Japanese Unexamined Patent Application, First Publication No. Sho 62-25744). According to the two-layer resist method, an organic film is formed on a substrate in the same manner as in the three-layer resist method and a photoresist film is formed thereon, and then a resist pattern is formed by conventional photolithography. Then, etching with oxygen plasma is performed using the resist pattern as a mask, thereby transferring the resist pattern onto the organic film. Etching with a fluorocarbon-based gas is performed using the resist pattern as a mask to form a pattern on the substrate.

Other pertinent prior art is as disclosed in EP-A-0908784, US-A-5601961, EP-A-0477691, US-A-2003/0064319, US-A-6106994 and US-A-5928836.

The film (hereinafter referred to as an underlying film) to be formed on the substrate or between the substrate and the resist layer like the above-described anti-reflection film, flattening film or organic film, requires resistance to etching with a fluorocarbon-based gas and the like used for etching of the substrate.

With further progress in high integration and fine size of the device in recent years, step-differences and wiring pattern of the device have also fine sizes. Therefore, the underlying film requires to have embedding characteristics capable of filling fine irregularities on the surface of the substrate. However, the underlying film, which has conventionally been used, was insufficient in embedding characteristics.

### DISCLOSURE OF THE INVENTION

An object of the present invention is to provide an undercoating material for forming an underlying film having excellent embedding characteristics, a resin for the undercoating material, and a resist pattern forming method.

The present inventors have intensively studied and found that embedding characteristics are improved by using a novolac resin wherein the total amounts of low molecular weight components having a molecular weight of 500 or less included in the novolac resin is 1% by mass or less. Thus, the present invention has been completed.

A first aspect for achieving the above object is a resin for an undercoating material for forming an underlying film between a substrate and a photoresist layer, wherein the resin is a novolac resin which comprises 1% by mass or less of low molecular weight components in which the content of the components is measured by gel permeation chromatography, and the components have a molecular weight of 500 or less.

A second aspect for achieving the above object is an undercoating material for forming an underlying film between a substrate and a photoresist layer, wherein the undercoating material comprises a novolac resin containing 1% by weight or less of low molecular weight components in which the content of the components is measured by gel permeation chromatography, and the components have a molecular weight of 500 or less.

A third aspect for achieving the above object is a multilayered resist pattern forming method, which comprises,
applying an undercoating material comprising at least a novolac resin which contains 1% by weight or less of low molecular weight components having a molecular weight of 500 or less on a substrate, wherein the content of the components is measured by gel permeation chromatography, and heating the undercoating material to form an underlying film;
forming at least one photoresist layer on the underlying film;
selectively exposing the photoresist layer to light;
alkali-developing the exposed photoresist layer to form a resist pattern on the photoresist layer; and etching the underlying film with oxygen plasma via the resist pattern as a mask, thereby transferring the resist pattern onto the underlying film.

A fourth aspect for achieving the above object is a laminate comprising at least a substrate, a photoresist layer, and an underlying film formed between the substrate and the photoresist layer, wherein
the underlying film contains a resin for an undercoating material wherein the resin is a novolac resin containing 1% by weight or less of low molecular weight components having a molecular weight of 500 or less, and the content of the components is measured by gel permeation chromatography.

### BEST MODE FOR CARRYING OUT THE INVENTION

Preferred examples of the present invention will now be described. However, the present invention is not limited by the following examples. For example, constituent elements of these examples may be appropriately combined.

The present invention relates to an undercoating material which can be used for forming an underlying film between a substrate and a photoresist layer in the production process of a semiconductor device, a liquid crystal display element and the like, a resin used for the undercoating material, and a multilayered resist pattern forming method.

Embodiments of the present invention will now be described.

### <Resin for undercoating material>

The resin for an undercoating material of the present invention is a novolac resin in which the content of low molecular weight components having a molecular weight of 500 or less, and preferably 200 or less, is 1% by mass or less, and preferably 0.8% by mass or less, as measured by gel permeation chromatography. The content of the low molecular weight components is preferably as small as possible, and is more preferably 0% by mass.

The "low molecular weight components having a molecular weight of 500 or less" can be detected as a low molecular fraction in which components having a molecular weight of 500 or less are comprised, when analyzed by a GPC method using polystyrene standards. Examples of the "low molecular weight components having a molecular weight of 500 or less" includes an unpolymerized monomer, and components having low polymerization degree such as those obtained by condensing 2 to 5 molecules of phenols with aldehydes, although it may vary depending on the molecular weight.

The content of the low molecular weight components having a molecular weight of 500 or less (% by mass) is derived from the analytical results obtained by the GPC method. For example, when the fraction number is provided as the axis of abscissa and the concentration is providing as the axis of ordinates to form a graph using the GPC method, the content of the components is determined from the graph. That is, the content of the components can be obtained by determining a ratio (%) of a specific area under the curve wherein the area corresponds to fractions of the low molecular weight components having a molecular weight of 500 or less, to a total area under the curve of the graph.

When the content of the low molecular weight components having a molecular weight of 500 or less is 1% by weight or less, embedding characteristics to the substrate having fine irregularities are improved. The reason why embedding characteristics are improved by reducing the content of the low molecular weight components is not clear, but is considered that dispersibility is lowered.

The mass-average molecular weight (Mw) (polystyrene equivalent molecular weight determined using gel permeation chromatography (GPC)) of the novolac resin is not specifically limited, but is usually from about 3000 to 100000, preferably from 5000 to 50000, and more preferably from 8000 to 30000.

MW of the novolac resin is preferably 50000 or less because embedding characteristics to the substrate having fine irregularities are excellent. In addition, Mw is preferably 5000 or more because etching resistance to a fluorocarbon-based gas is excellent.

The resin for an undercoating material of the present invention is cured by heating preferably to 200°C or higher, and more preferably about 200 to 300°C, to form an alkaliinsoluble underlying film. When a conventional resin for undercoating material is used, sublimate tends to be formed from the undercoating material during heating in the formation of an underlying film and the sublimate adheres to peripheral devices, which results in poor yield. When using the resin for an undercoating material of the present invention, the amount of the sublimate can decrease.

When the content of the low molecular weight components is reduced, resistance of the underlying film containing the resin to an organic solvent is improved. Therefore, when a resist composition is applied on the underlying film, intermixing is less likely caused by the organic solvent contained in the resist composition.

The resin for an undercoating material of the present invention is a novolac resin and is therefore excellent in absorptivity of excimer laser such as KrF or ArF. Therefore, the underlying film containing the resin for undercoating material of the present invention also has an anti-reflection effect.

The resin for an undercoating material of the present invention may be prepared by preparing a novolac resin having Mw of 2000 to 40000 and removing low molecular weight components having a molecular weight of 500 or less from the novolac resin, thereby to adjust Mw within a range from 5000 to 50000.

The novolac resin can be prepared by the method used to commonly prepare the novolac resin. For example, it can be obtained by addition-condensing an aromatic compound having a phenolic hydroxyl group (hereinafter merely referred to as "phenols") with aldehydes in the presence of an acid catalyst.

Examples of the phenols include phenol, o-cresol, m-cresol, p-cresol, o-ethylphenol, m-ethylphenol, p-ethylphenol, o-butylphenol, m-butylphenol, p-butylphenol, 2,3-xylenol, 2,4-xylenol, 2,5-xylenol, 2,6-xylenol, 3,4-xylenol, 3,5-xylenol, 2,3,5-trimethylphenol, 3,4,5-trimethylphenol, p-phenylphenol, resorcinol, hydroquinone, hydroquinone monomethyl ether, pyrogallol, phloroglucinol, hydroxydiphenyl, bisphenol A, gallic acid, gallic acid ester, α-naphthol, and β-naphthol.

The novolac resin obtained by using phenols containing m-cresol is particularly preferable because embedding characteristics are excellent.

The content of m-cresol in phenols is preferably from 20 to 100 mol%, and more preferably from 40 to 90 mol%.

Phenols preferably contains p-cresol, in addition to m-cresol because film-forming properties of the underlying film are improved. When film-forming properties of the underlying film are improved, the occurrence of intermixing is prevented when a resist composition is applied on the underlying film to form a photoresist layer.

When phenols contain p-cresol, the content is preferably from 10 to 50 mol%, and more preferably from 15 to 30 mol%.

Examples of aldehydes include formaldehyde, furfural, benzaldehyde, nitrobenzaldehyde, and acetaldehyde. In view of industrial productivity, formaldehyde is most preferable.

The catalyst used in the addition condensation reaction is not specifically limited. As the acid catalyst, for example, hydrochloric acid, nitric acid, sulfuric acid, formic acid, oxalic acid, acetic acid and the like can be used.

The resin for undercoating material of the present invention can also be prepared by removing low molecular weight components having a molecular weight of 500 or less from a novolac resin which is commercially available for a resist.

Adjustment of Mw of the novolac resin and removal of low molecular weight components having a molecular weight of 500 or less can be conducted by the following fractional precipitation treatment. First, a novolac resin (Mw: 2000 to 40000) which is a condensation product obtained described above is dissolved in a polar solvent and then the resulting solution is mixed with a poor solvent such as water, heptane, hexane, pentane, cyclohexane or the like. At this time, the low molecular weight components having a molecular weight of 500 or less is dissolved well in the poor solvent. Therefore, by collecting the precipitate due to filtration, a resin for an undercoating material of the present invention in which the content of the low molecular weight components having a molecular weight of 500 or less is reduced can be obtained.

Examples of the polar solvent include alcohols such as methanol and ethanol; ketones such as acetone and methyl ethyl ketone; glycol ether esters such as ethylene glycol monoethyl ether acetate; and cyclic ethers such as tetrahydrofuran. If necessary, these polar solvents and poor solvents can be used alone or in combination.

Mw of the precipitate (resin for an undercoating material of the present invention) and the content of the low molecular weight components having a molecular weight of 500 or less can be obtained by the GPC method, as described above.

The novolac resin has excellent embedding characteristics and is used suitably for an undercoating material for forming the underlying film such as an anti-reflection layer, underlying film, a flattening film, an organic film, or the like, between the substrate and the photoresist layer.

### <Undercoating material>

The undercoating material of the present invention is an undercoating material for forming an underlying film between a substrate and a photoresist layer. The undercoating material comprises, as a resin for forming a coating film (hereinafter referred to as a component (A)), at least a resin for an undercoating material of the present invention (hereinafter referred to as a resin (A1)).

### Component (A)

### Resin (A1)

The content of the resin (A1) in the component (A) is preferably from 20 to 100% by mass, more preferably from 70 to 100% by mass, and most preferably 100% by mass.

The undercoating material of the present invention may contain a compound(s) which can be commonly used as a resin for forming a coating film in the production of a semiconductor device and a liquid crystal display element as a component (A), in addition to the resin (A1).

The resin for forming a coating film is not specifically limited as far as it has resistance to an alkali developing solution and can be etched with oxygen plasma, and also has resistance to a fluorocarbon-based gas which is commonly used for etching of a silicon substrate. Examples of the resin for forming a coating film include a novolac resin other than the resin (A1) (hereinafter referred to as a resin (A2)) and an acrylic resin (hereinafter referred to as a resin (A3)).

### Resin (A2)

As the resin (A2), resins which are commonly used for resist composition can be used.

The resin (A2) has Mw within a range from 3000 to 30000, and preferably from 6000 to 20000. Mw which is less than 3000 is not preferable because resistance to an alkali developing solution is lowered. Mw which is more than 30000 is not preferable because embedding characteristics become inferior.

### Resin (A3)

As the resin (A3), resins which are commonly used as a resin for undercoating material can be used. Examples of the resin include an acrylic resin comprising a constituent unit derived from a polymerizable compound having an ether bond and a constituent unit derived from a polymerizable compound having a carboxyl group.

Examples of the polymerizable compound having an ether bond include (meth)acrylic acid derivatives having an ether bond and an ester bond, such as 2-methoxyethyl (meth)acrylate, methoxytriethylene glycol (meth)acrylate, 3-methoxybutyl (meth)acrylate, ethylcarbitol (meth)acrylate, phenoxypolyethylene glycol (meth)acrylate, methoxypolypropylene glycol (meth)acrylate, and tetrahydrofurfuryl (meth)acrylate. The (meth)acrylate is a generic name of methacrylate and acrylate, and these compounds can be used alone or in combination.

Examples of the polymerizable compound having a carboxyl group include monocarboxylic acids such as acrylic acid, methacrylic acid, and crotonic acid; dicarboxylic acids such as maleic acid, fumaric acid, and itaconic acid; and compounds having a carboxyl group and an ester bond, such as 2-methacryloyloxyethylsuccinic acid, 2-methacryloyloxyethylmaleic acid, 2-methacryloyloxyethylphthalic acid, and 2-methacryloyloxyethylhexahydrophthalic acid. Among these compounds, acrylic acid and methacrylic acid are preferable. The aforementioned compounds can be used alone or in combination.

An acrylic resin having an alicyclic moiety or an aromatic ring in the side chain is preferably used because it is excellent in resistance to an alkali developing solution.

### Component (B)

The undercoating material of the present invention preferably contains a phenol derivative having a molecular weight of 200 or more esterified with naphthoquinonediazidosulfonic acid (hereinafter referred to as a component (B)), in addition to the above-described component (A). The component (B) improves film-forming properties of the underlying film. Therefore, when the undercoating material does not contain the component (B), it is preferred to heat the undercoating material at a temperature of about 300°C so as to sufficiently form a film, although it varies with the composition of the component (A). When the undercoating material contains the component (B), an underlying film having excellent etching resistance and organic solvent resistance can be obtained even if heating temperature is about 200°C. To obtain the aforementioned phenol derivative, it is preferred to conduct esterification by using halide of sulfonic acid such as sulfonic acid chloride, as the aforementioned sulfonic acid, because it is excellent in reactivity. Therefore, the sulfonic acid also includes a reactive derivative such as halide.

The reason why film-forming properties are improved by using the component (B) is considered that, the component (B) can serve as a crosslinking agent for the component (A) when they are heated at a temperature of 200°C or higher.

Furthermore, when the component (B) is used, the amount of the generated sublimate can be decreased as compared with the case wherein a crosslinking agent commonly used in the undercoating material is utilized. The reason is considered that, since the component (B) is likely to crosslink with the component (A), an amount of the sublimate, which is derived from the low molecular weight components included in the component (A) and the uncrosslinked component (B), is small.

More specific examples of the component (B) include compounds represented by the following general formulas (I) and (II) which are proposed as photosensitive components of a positive photosensitive resin composition in Japanese Unexamined Patent Application, First Publication No. 2002-278062. These compounds may be used alone or in combination of two or more.

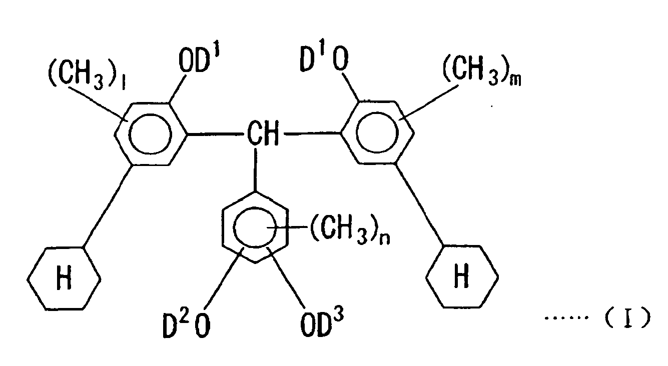

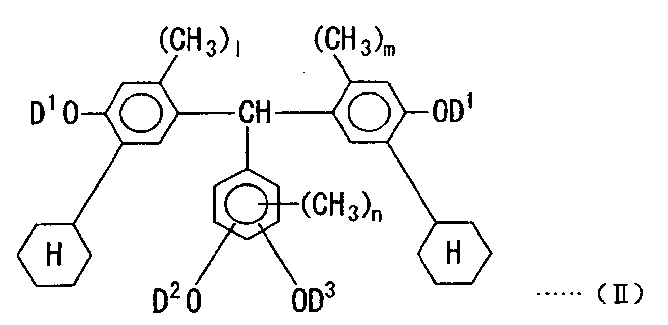

In the above formulae, at least one of D¹, D² and D³ represents a naphthoquinone-1,2-diazidosulfonyl group and the remainder represent a hydrogen atom; and 1, m and n represents an integer of 0 to 3.

An esterification reaction product of bis(5-cyclohexyl-4-hydroxy-2-methylphenyl)-3,4-hydroxyphenylmethane and naphthoquinone-1,2-diazido-5-sulfonylchloride has particularly excellent effect for improving film-forming properties.

The content of the component (B) is preferably from 0.5 to 20% by mass, and more preferably from 5 to 15% by mass, based on the component (A).

The undercoating material of the present invention may contain additives, which can mix with the component (A) and the like, as far as the effects of the present invention are not adversely affected. Examples of the additive include surfactants for improving coatability and preventing striation, light-absorbing substances which exhibit absorptivity to exposure light and can prevent standing wave and irregular refraction caused by reflection from the substrate, additive resins for improving performances of the underlying film, dissolution inhibitors, plasticizers, stabilizers, colorants, and anti-halation agents.

Examples of the surfactant include fluorinecontaining surfactants such as XR-104 (manufactured by Dainippon Ink and Chemical, Incorporated). These surfactants may be used alone or in combination.

The light-absorbing substance can be appropriately selected from those which have conventionally been used as components of an undercoating material and an anti-reflection layer. These light-absorbing substances may be used alone or in combination.

The undercoating material of the present invention is preferably used in the form of a solution prepared by dissolving arbitrary components such as components (A), (B) and the like in a suitable solvent.

Examples of the solvent include ketones such as acetone, methyl ethyl ketone, cyclopentanone, cyclohexanone, methyl amyl ketone, methyl isoamyl ketone, and 1,1,1-trimethylacetone; polyhydric alcohols and derivatives thereof, such as ethylene glycol, ethylene glycol monoacetate, diethylene glycol or diethylene glycol monoacetate, propylene glycol, and propylene glycol monoacetate, or monomethyl ether, monoethyl ether, monopropyl ether, monobutyl ether or monophenyl ether thereof; cyclic ethers such as dioxane; and esters such as ethyl lactate, methyl acetate, ethyl acetate, butyl acetate, methyl pyruvate, ethyl pyruvate, methyl 3-methoxypropionate, and ethyl 3-ethoxypropionate. These solvents may be used alone or in combination of two or more.

The undercoating material of the present invention can be applied to any resist compositions such as negative and positive resist compositions. According to an exposure light source, commercially available resist compositions can be selected and used.

Examples of those, which can use the undercoating material of the present invention as an undercoating, include a non-chemically amplified type positive resist composition containing a naphthoquinonediazido compound and a novolac resin, and a chemically amplified type resist composition containing a resin component whose alkali solubility changes due to an action of an acid and an acid generating component capable of generating an acid under exposure.

When using KrF or ArF excimer laser, or a light source having a wavelength shorter than these lasers, a chemically amplified resist composition is preferably used because it is excellent in fine resolution.

The chemically amplified resist composition includes a positive resist composition containing a photo acid generator and an alkali insoluble resin having an dissolution inhibiting group which is an acid dissociative group, wherein alkali solubility of the resin is enhanced due to an acid, and a negative resist composition containing a photo acid generator, a crosslinking agent and an alkali soluble resin.

In case of the positive resist composition, when an acid is generated from the photo acid generator under exposure in the formation of a resist pattern, the dissolution inhibiting group is dissociated by the acid and thus the composition becomes soluble in an alkali. In case of the negative resist composition, when an acid is generated under exposure, the alkali soluble resin is crosslinked with the crosslinking agent by the action of the acid and thus the composition becomes insoluble in an alkali.

As the chemically amplified resist composition for KrF excimer laser, those containing polyhydroxystyrene having a dissolution inhibiting group such as t-butoxycarbonyl group are known.

As the chemically amplified resist composition for ArF excimer laser, a composition including a resin in which an aliphatic polycyclic group such as adamanthyl group is introduced in the side chain of a methacrylic resin, a composition containing a resin having an aliphatic polycyclic group such as norbornyl group in the main chain and the like are known.

When a multilayer process such as two-layer or three-layer resist method is conducted, a chemically amplified resist containing a silicon-containing polymer is preferably used.

The underlying film obtained by using the undercoating material of the present invention is insoluble in an alkali developing solution which is used to develop a photoresist layer after exposure, and can be etched with oxygen plasma, and is also excellent in embedding characteristics to the substrate. It is also excellent in etching resistance to a fluorocarbon-based gas, and generation of the sublimate can be suppressed when the film is formed. Furthermore, when using an excimer laser such as KrF or ArF excimer laser, or a light source having a wavelength shorter than that of the laser, the anti-reflection effect can be also exerted.

Therefore, the undercoating material of the present invention is preferably used as an undercoating material used for forming the aforementioned anti-reflection layer or flattening film, or the underlying film such as organic film in the multilayer process such as two-layer or three-layer resist method.

When using as the anti-reflection layer, the thickness of the underlying film is preferably 30 to 500 nm, and more preferably from 50 to 250 nm. When using as a flattening film, the thickness is preferably from 100 to 1000 nm, and more preferably from 200 to 600 nm. When using as an organic film in the multilayer process, the thickness is preferably 200 nm or more.

### <Multilayered resist pattern forming method>

The multilayered resist pattern forming method of the present invention can be carried out by using the undercoating material of the present invention as follows.

First, an undercoating material solution prepared by dissolving the undercoating material of the present invention in the above-described solvent is rotary-coated on a substrate such as silicon wafer using a spinner. Then, by heating the coated substrate at a temperature of 200°C or higher, and preferably from 200 to 300°C, an underlying film having preferably a thickness of 200 nm or more, and more preferably from 250 to 500 nm is formed.

This underlying film becomes insoluble in an alkali by film formation due to heating (baking). Also resistance to an organic solvent is enhanced due to heating and thus intermixing is less likely to occur when a photoresist layer is formed by applying a resist composition on the underlying film.

The substrate is not specifically limited and a conventionally known substrate can be used. Examples of the substrate include substrates for electronic components, and substrates having a predetermined wiring pattern and/or level difference formed thereon, and the like.

Examples of the substrate material include metals such as silicon wafer, copper, chromium, iron, and aluminum, and glass.

Examples of the material for wiring pattern thereof include silicon, copper, solder, chromium, aluminum, nickel, gold, or alloys thereof.

Then, a resist composition is applied on the underlying film using a spinner and prebaked at a temperature of 80 to 150°C for 40 to 120 seconds, and preferably 60 to 90 seconds to form a photoresist layer.

The thickness of the photoresist layer is preferably from 10 to 500 nm, and more preferably from 30 to 300 nm. When using a chemically amplified resist containing a silicon-containing polymer, the thickness is preferably from 100 to 200 nm, and more preferably from 130 to 170 nm.

In case of the two-layer resist method, the resist film may be directly formed on the underlying film. In case of the three-layer resist method, the resist film can be formed on the underlying film via a silicon-based coating film.

This photoresist layer is selectively exposed to, for example, KrF excimer laser via a desired mask pattern using a KrF lithography. When a chemically amplified resist is used as the resist composition, the photoresist layer is subjected to PEB (exposure post baking) at a temperature of 80 to 150°C for 40 to 120 seconds, and preferably from 60 to 90 seconds after exposure.

As the light source used for exposure, a KrF or ArF excimer laser is useful. It is also possible to use g-ray or i-ray having a wavelength longer than that of the aforementioned laser, F₂ laser having a wavelength shorter than that of the laser, and radiations such as EUV (extreme ultraviolet ray), VUV (vacuum ultraviolet ray), electron beam, X-ray, and soft X-ray effectively. Then, a development treatment is performed using an alkali developing solution, for example, an aqueous tetramethylammonium hydroxide having a concentration of 0.05 to 10% by mass, and preferably 0.05 to 3% by mass. When the resist is positive, the exposed area is selectively dissolved and removed to form a resist pattern which is equal to a mask pattern. When the resist is negative, the unexposed area is selectively dissolved and removed to form a resist pattern which is equal to a mask pattern. Thus, the resist pattern, which has high fidelity regarding the mask pattern, can be formed on the photoresist layer.

In case of the two-layer resist method, the underlying film is etched with oxygen plasma via the resulting resist pattern as a mask pattern, thereby to transfer the resist pattern onto the underlying film. In case of the three-layer resist method, after etching a silicon-based coating film with a fluorocarbon-based gas capable of etching the silicon-based coating film, the underlying film is etched with oxygen plasma in the same manner, thereby to transfer the resist pattern onto the underlying film.

Conditions of etching with the oxygen plasma and fluorocarbon-based gas can be optionally selected.

Such a method for forming a multilayered resist pattern of the present invention has the flattening effect because the underlying film is excellent in embedding characteristics to the substrate. Since the underlying film is excellent in etching resistance to a fluorocarbon-based gas, the substrate can be etched using this film as a mask. The sublimate hardly generates during heating at high temperature in case of forming the underlying film and thus production yield of the semiconductor device is improved. Because of excellent anti-reflection effect of the underling film to a light source having a short wavelength such as KrF or ArF, it is made possible to form a resist pattern, which has high rectangularity and has also high fidelity to a mask pattern, on the photoresist layer.

### EXAMPLES

The present invention will now be described in detail by way of examples, but the present invention is not limited by the following examples.

### Synthetic example 1

To 0.5 mols of a mixture of m-cresol:p-cresol = 6:4 (mass ratio) was added 15 mL of formalin, and then the solution was condensed by a conventional method using an oxalic acid catalyst to obtain a novolac resin having Mw of 12000. The resulting resin was dissolved in methanol at room temperature to obtain a 15% (by mass) solution. Water which was two times larger than the methanol was added and the resulting precipitate was taken out to obtain a novolac resin (a1) wherein low molecular weight components having a molecular weight of less than 500 was removed.

The resulting precipitate (novolac resin (a1)) was subjected to gel permeation chromatography (GPC) using polystyrene standards under the following conditions. As a result, Mw of the novolac resin (a1) was 20000 and the content of the low molecular weight components having a molecular weight of 500 or less in the novolac resin (a1) was 0.9% by mass.
Apparatus: SYSTEM 11 (manufactured by Showa Denko K.K.)
Precolumn: KF-G
Column: KF-802
Detector: UV41 (measured at 280 nm)
Solvent: measured at 35°C while flowing tetrahydrofuran at a flow rate of 1.0 mL/min.

### Example 1

100 parts by mass of the novolac resin (a1) obtained in Synthetic example 1 was dissolved in a 5-fold amount of propylene glycol methylether acetate (PGMEA). In the solution, 10 parts by mass of an esterification reaction product (phenol derivative) of bis(5-cyclohexyl-4-hydroxy-2-methylphenyl)-3,4-hydroxyphenylmethane and naphthoquinone-1,2-diazido-5-sulfonylchloride was dissolved. Furthermore, 6 parts by mass of a surfactant XR-104 (manufactured by Dainippon Ink and Chemical, Incorporated) was added to prepare an undercoating material solution.

The resulting undercoating material solution was coated on a silicon wafer using a spinner and baked at 250°C for 90 seconds to form a 500 nm thick underlying film.

Then, a positive resist composition containing a silicon-containing polymer was coated on the underlying film using a spinner and baked at 90°C for 90 seconds to form a 150 nm thick photoresist layer. The photoresist layer was selectively exposed to KrF excimer laser via a mask pattern using a KrF lithography NSR-S203 (manufactured by Nikon Corporation; NA = 0.68).

The resist layer was subjected to a PEB treatment under the conditions of a temperature of 90°C for 90 seconds and developed with an aqueous 2.38% (by mass) tetramethylammonium hydroxide solution at 23°C for 60 seconds. As a result of these treatments, 150 nm L&S pattern was formed on the photoresist layer.

The underlying film was subjected to dry etching for the resulting L&S pattern with plasma obtained from a gas mixture of oxygen and nitrogen using a high vacuum RIE apparatus (manufactured by Tokyo Ohka Kogyo Co., Ltd.) to form a L&S pattern (line and space pattern) having high rectangularity on the underlying film.

### Comparative Example 1

In the same manner as in Example 1, except that a conventional undercoating material solution composed of a photoresist THMR-iP5700 for i-ray (manufactured by Tokyo Ohka Kogyo Co., Ltd.) comprising a novolac resin having Mw of 9000 and containing 5% by mass of low molecular weight components having a molecular weight of 500 or less was used in place of the undercoating material solution of Example 1, a resist pattern was formed.

### Comparative Example 2

In the same manner as in Example 1, except that a conventional undercoating material solution obtained by adding a crosslinking agent to a copolymer of benzyl methacrylate and methacrylic acid was used in place of the undercoating material solution of Example 1, a resist pattern was formed.

### (Evaluation)

With respect to the respective undercoating material solutions used in Example 1, Comparative Example 1 and Comparative Example 2, the following characteristics were evaluated.

### [Embedding characteristics]

After preparing a wafer with an oxide film having a 200 nm hole pattern formed thereon, the undercoating material solution of Example 1 was coated on the wafer in a thickness of 500 nm and subjected to a heat treatment at 250°C. The wafer was cut and then profile of the hole pattern was observed. As a result, it was confirmed that satisfactory embedding could be achieved in the state of being free from bubbles. In the undercoating material solutions of Comparative Examples 1 and 2, satisfactory embedding could not be achieved because cavities were formed at the bottom of holes.

### [Sublimate]

When the films were formed using an undercoating material solution in pattern formation of Example 1, the amount of a sublimate adhered to a top board located about 30 cm above a substrate was determined by dissolving the sublimate in PGMEA (propylene glycol monomethyl ether acetate)and measuring the content using gas chromatography. As a result, the amount of the sublimate of the undercoating material solution used in Example 1 accounted for 1/20 or less of that of the undercoating material solutions of Comparative Examples 1 and 2.

### [Etching resistance]

In the same manner as described above, only a 500 nm thick underlying film was formed on a silicon wafer and the underlying film was etched with a gas mixture of CF₄ and CHF₃, and then the etch rate was measured. The etch rate of the underlying film of Example 1 was 0.9 times larger than that of Comparative Example 1. The etch rate of the underlying film of Comparative Example 2 was 1.4 times larger than that of Comparative Example 1.

As is apparent from these results, according to the above-described multilayer (two- or three-layer) resist method, an underlying film having excellent embedding characteristics can be formed by using an undercoating material containing a resin for a undercoating material of the present invention. An amount of a sublimate generated by heating in case of film formation was small, and resistance of etching to a fluorocarbon-based gas was excellent because of small etch rate. As is apparent from the results shown of Example 1, since a resist pattern, which has high fidelity to a mask pattern and also has high rectangularity, could be formed on a photoresist layer, the underlying film has an anti-reflection effect.

### INDUSTRIAL APPLICABILITY

An underlying film having high embedding characteristics can be formed by using a resin for a undercoating material of the present invention, an undercoating material containing the resin, and a resist pattern forming method using the undercoating material.

## Claims

1. A multilayered resist pattern forming method, which comprises,
applying an undercoating material comprising at least a novolac resin which contains 1% by weight or less of low molecular weight components having a molecular weight of 500 or less on a substrate, wherein the content of the low molecular weight components is measured by gel permeation chromatography, and heating the undercoating material to form an underlying film;
forming at least one photoresist layer on the underlying film;
selectively exposing the photoresist layer to light;
alkali-developing the exposed photoresist layer to form a resist pattern on the photoresist layer; and
etching the underlying film with oxygen plasma via the resist pattern as a mask, thereby transferring the resist pattern onto the underlying film.

2. A laminate comprising at least a substrate, a photoresist layer, and an underlying film formed between the substrate and the photoresist layer, wherein
the underlying film contains a resin for an undercoating material wherein the resin is a novolac resin containing 1% by weight or less of low molecular weight components having a molecular weight of 500 or less, and
the content of the low molecular weight components is measured by gel permeation chromatography.

3. Use of a material for forming an underlying film between a substrate and a photoresist layer, wherein
the material comprises a novolac resin containing 1% by weight or less of low molecular weight components in which the content of the components is measured by gel permeation chromatography, and the components have a molecular weight of 500 or less, and
the mass-average molecular weight of the novolac resin is 8,000 to 30,000, wherein
the content of the low molecular weight components and the novolac resin are measured by gel permeation chromatography.

4. The use according to claim 3, wherein the novolac resin is a condensate of aldehydes and phenols containing at least m-cresol.

5. The use according to claim 4, wherein the phenols comprise 20 to 100mol% of m-cresol.

6. The use according to claim 4, wherein the phenols further comprise p-cresol. 10

7. The use according to claim 6, wherein the phenols contain 10 to 50mol% of p-cresol.

8. The use according to claim 3, wherein the material further comprises a phenol derivative having a molecular weight of 200 or more esterified by naphthoquinonediazido sulfonic acid.

9. The use according to claim 8, wherein the phenol derivative contains at least one compound selected from the group consisting of compounds represented by the following general formulas (I) and (II): 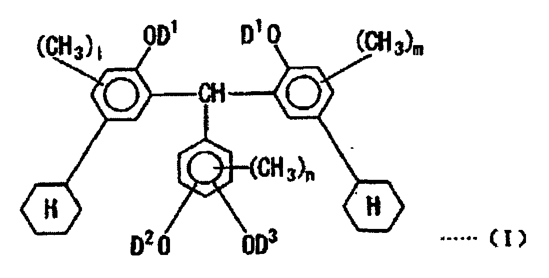 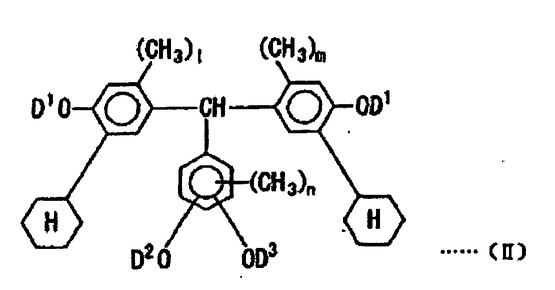 wherein at least one of D¹, D² and D³ represents a naphthoquinone-1,2-diazidosulfonyl group and the remainder represent a hydrogen atom; and 1, m and n represent an integer of 0 to 3.

10. The use according to claim 9, wherein the phenol derivative is an esterification reaction product of bis(5-cyclohexyl-4-hydroxy-2-methylphenyl)-3,4-hydroxyphenylmethane and naphthoquinone-1,2-diazido-5-sulfonylchloride.

## Patentansprüche

1. Ein mehrschichtiges Resistmuster-Bildungsverfahren, welches umfasst
Anbringen eines Grundschichtmaterials umfassend mindestens ein Novolak-Harz, das 1 Gew.-% oder weniger von Komponenten mit geringem Molekulargewicht, die ein Molekulargewicht von 500 oder weniger haben, enthält, auf einem Substrat, wobei der Gehalt der Komponenten mit geringem Molekulargewicht durch Gelpermeationschromatographie gemessen wird, und Erhitzen des Grundschichtmaterials um einen Unterlegungsfilm zu bilden;
Bilden von wenigstens einer Fotolackschicht auf dem Unterlegungsfilm;
selektives Belichten der Fotolackschicht mit Licht;
Alkali-Entwickeln der belichteten Fotolackschicht, um ein Resistmuster auf der Fotolackschicht zu bilden; und
Ätzen des Unterlegungsfilms mit Sauerstoffplasma mithilfe des Resistmusters als Maske, wobei das Resistmuster auf den Unterlegungsfilm übertragen wird.

2. Ein Laminat, umfassend wenigstens ein Substrat, eine Fotolackschicht, und einen Unterlegungsfilm, der zwischen Substrat und der Fotolackschicht ausgebildet ist, wobei
der Unterlegungsfilm ein Harz für ein Grundschichtmaterial enthält, wobei das Harz ein Novolak-Harz ist, das 1 Gew.-% oder weniger von Komponenten mit geringem Molekulargewicht, die ein Molekulargewicht von 500 oder weniger haben, enthält, und
der Gehalt der Komponenten mit geringem Molekulargewicht durch Gelpermeationschromatographie gemessen wird.

3. Verwendung eines Materials zum Bilden eines Unterlegungsfilms zwischen einem Substrat und einer Fotolackschicht, wobei
das Material ein Novolak-Harz umfasst, das 1 Gew.-% oder weniger von Komponenten mit geringem Molekulargewicht enthält, in welchem der Gehalt der Komponenten durch Gelpermeationschromatographie gemessen wird, und die Komponenten ein Molekulargewicht von 500 oder weniger haben, und
das gewichtsmittlere Molekulargewicht des Novolak-Harzes 8000 bis 30000 ist, wobei
der Gehalt der Komponenten mit geringem Molekulargewicht und des Novolak-Harzes durch Gelpermeationschromatographie gemessen werden.

4. Verwendung nach Anspruch 3, wobei das Novolak-Harz ein Kondensat von Aldehyden und Phenolen ist und wenigstens m-Kresol enthält.

5. Verwendung nach Anspruch 4, wobei die Phenole 20 bis 100 mol% m-Kresol umfassen.

6. Verwendung nach Anspruch 4, wobei die Phenole ferner p-Kresol umfassen.

7. Verwendung nach Anspruch 6, wobei die Phenole 20 bis 50 mol% p-Kresol enthalten.

8. Verwendung nach Anspruch 3, wobei das Material ferner ein Phenolderivat umfasst, das ein Molekulargewicht von 200 oder mehr hat und durch Naphthoquinondiazidosulfonsäure verestert ist.

9. Verwendung nach Anspruch 8, wobei das Phenolderivat wenigstens eine Verbindung enthält, die aus der Gruppe bestehend aus den durch die folgenden allgemeinen Formeln (I) und (II) dargestellten Verbindungen ausgewählt ist: 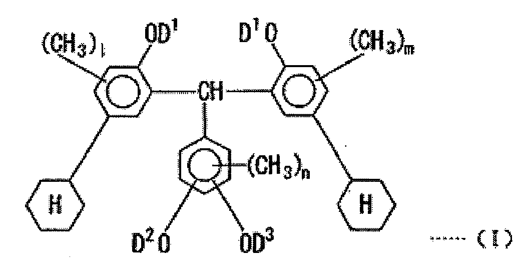 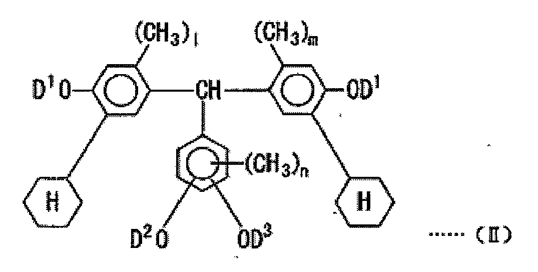 wobei wenigstens eines von D¹, D² und D³ eine Naphthoquinon-1,2-diazidosulfonylgruppe und der Rest ein Wasserstoffatom darstellen; und l, m und n ganze Zahlen von 0 bis 3 darstellen.

10. Verwendung nach Anspruch 9, wobei das Phenolderivat ein Veresterungsreaktionsprodukt von bis(5-cyclohexyl-4-hydroxy-2-methylphenyl)-3,4-Hydroxyphenylmethan und Naphthoquinon-1,2-diazido-5-sulfonylchlorid ist.

## Revendications

1. Un procédé pour former un motif de résist à plusieurs couches qui comprend
application, sur un substrat, d'une matière de sous-couche comportant au moins une résine novolaque qui contient 1% ou moins de 1% en poids de composants de faible poids moléculaire dont le poids moléculaire est égal ou inférieur à 500, dans laquelle la teneur en composants de faible poids moléculaire est mesurée par chromatographie sur gel perméable, et chauffage de la matière de sous-couche pour former un film sous-jacent;
formation d'au moins une couche de photorésist sur le film sous-jacent;
exposition sélective de la couche de photorésist à la lumière;
développement en milieu alcalin de la couche de photorésist exposée pour former un motif de résist sur la couche de photorésist; et
gravure du film sous-jacent avec du plasma d'oxygène en utilisant le motif de résist comme masque, le transférant ainsi sur le film sous-jacent.

2. Un stratifié comportant au moins un substrat, une couche de photorésist et un film sous-jacent qui est formé entre le substrat et la couche de photorésist, dans lequel,
le film sous-jacent contient une résine pour une matière de sous-couche, cette résine étant une résine novolaque qui contient 1% ou moins de 1 % en poids de composants de faible poids moléculaire, dont le poids moléculaire est égal ou inférieur à 500, et
la teneur en composants de faible poids moléculaire étant mesurée par chromatographie sur gel perméable.

3. Utilisation d'une matière pour former un film sous-jacent entre un substrat et une couche de photorésist, dans laquelle la matière comprend une résine novolaque qui contient 1% ou moins de 1% en poids de composants de faible poids moléculaire, où la teneur en composants est mesurée par chromatographie sur gel perméable et dont les composants ont un poids moléculaire égal ou inférieur à 500, et
le poids moléculaire moyen de la résine novolaque se situe entre 8000 et 30000, la teneur en composants de faible poids moléculaire et en résine novolaque étant mesurée par chromatographie sur gel perméable.

4. Utilisation selon la revendication 3, dans laquelle la résine novolaque est un condensat d'aldéhydes et de phénols et contient au moins du méta-crésol.

5. Utilisation selon la revendication 4, dans laquelle les phénols comportent de 20 à 100 %mol de méta-crésol.

6. Utilisation selon la revendication 4, dans laquelle les phénols comportent également du para-crésol.

7. Utilisation selon la revendication 6, dans laquelle les phénols comportent de 20 à 50 %mol de para-crésol.

8. Utilisation selon la revendication 3, dans laquelle la matière comporte également un dérivé phénol, dont le poids moléculaire est égal ou supérieur à 200 et qui est estérifié par de l'acide naphthoquinonediazoidosulfonique.

9. Utilisation selon la revendication 8, dans laquelle le dérivé phénol contient au moins un composé choisi dans le groupe constitué par les composés représentés par les formules générales suivantes (I) et (II) : 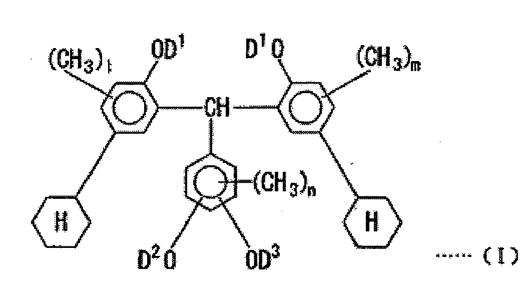 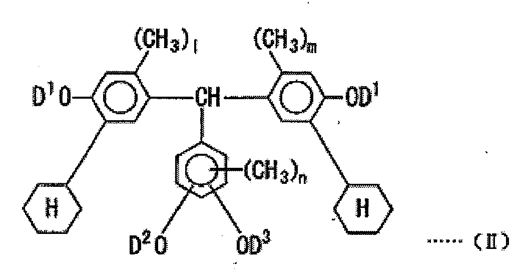 dans lesquelles au moins un des D¹, D² et D³ représente un groupe naphthoquinone-1,2-diazidosulfonyle et le reste représente un atome d'hydrogène; et l, m et n représentent des nombres entiers de 0 à 3.

10. Utilisation selon la revendication 9, dans laquelle le dérivé phénol est un produit de la réaction d'estérification du bis(5-cyclohexyl-4-hydroxy-2-méthylphényl)-3,4-hydroxyphénylméthane et du chlorure de naphthoquinone-1,2-diazido-5-sulfonyle.
